(19) Europäisches Patentamt
European Patent Office
Office européen des brevets

(11) **EP 1 670 596 B1**

(12) **EUROPEAN PATENT SPECIFICATION**

(45) Date of publication and mention
of the grant of the patent:
**02.06.2010 Bulletin 2010/22**

(51) Int Cl.:
***B05D 5/04*** *(2006.01)*

(21) Application number: **04742950.1**

(22) Date of filing: **18.06.2004**

(86) International application number:
**PCT/GB2004/002591**

(87) International publication number:
**WO 2005/014184 (17.02.2005 Gazette 2005/07)**

(54) **METHOD OF PATTERN COATING**

MUSTERBESCHICHTUNGSVERFAHREN

PROCEDE POUR REVETEMENTS A MOTIFS

(84) Designated Contracting States:
**DE FR GB**

(30) Priority: **18.07.2003 GB 0316926**

(43) Date of publication of application:
**21.06.2006 Bulletin 2006/25**

(73) Proprietor: **Eastman Kodak Company
Rochester NY 14650-2201 (US)**

(72) Inventors:
• **BOWER, Christopher, Lee
Headington,
Oxford OX3 8LP (GB)**
• **SIMISTER, Elizabeth, Anne
Watford,
Hertfordshire WD17 3DQ (GB)**

• **BLAKE, Terence, Desmond
Tring,
Hertfordshire HP23 5JH (GB)**
• **BONNIST, Eleanor
Minehead,
Somerset TA24 8EE (GB)**

(74) Representative: **Weber, Etienne Nicolas et al
Kodak
Etablissement de Chalon
Campus Industriel - Département Brevets
Route de Demigny - Z.I. Nord - B.P. 21
71102 Chalon sur Saône Cedex (FR)**

(56) References cited:
EP-A- 0 769 331　　　EP-A- 1 011 298
US-A- 4 729 310　　　US-A- 5 656 331
US-A1- 2003 108 725

**Description**

**Field of the Invention**

The present invention relates to the field of coating, in particular to the roll to roll coating of well defined discrete areas of a continuous web of material.

**Background of the Invention**

It is known to use the basic principle of differential wetting to rearrange liquids on a solid support, such as a silicon wafer. The general principle relies on the liquid spontaneously moving from the lyophobic (solvent hating) areas onto the lyophilic (solvent loving) areas of the substrate or support.

WO 02/38386 discloses a process and apparatus for formation of patterns using temperature gradients. Thermal gradients are used to rearrange liquids after coating.

EP 0882593 discloses a method of forming a hydrophobic/hydrophilic front face of an inkjet printer. Hydrophobic surfaces are required around the nozzles of an inkjet head to repel ink from the nozzle and hydrophilic regions are required to pull ink away from the hydrophobic regions.

WO 01/62400 discloses the use of a hydrophobic effect to create polymer micro lens arrays by dip coating a support with patterned wettability.

US 6048623 discloses a method of contact printing on gold coated films. This is used to create self assembled monolayers using an elastomeric stamp

WO 01/47045 discloses the fabrication of electronic devices on flexible plastic substrates using self assembled monolayers to limit the spread of inkjet printed polymers.

**Problem to be solved by the Invention**

All the known prior art is concerned with batch processed supports. None of the prior art discloses a technique for the use of any means of differential wetting for the production of coated webs of flexible material in a roll to roll manner. It is desirable to be able to deposit a liquid onto specified regions of the flexible material whilst leaving other regions uncoated.

**Summary of the Invention**

The method of the invention utilises the controlled deposition of a liquid to produce a pattern on the support. This is achieved by patterning the support web with a hydrophobic or an oleophobic (to allow patterning of aqueous liquids or of non-aqueous liquids respectively) material to form a mask. The mask re-arranges the coated liquid into the desired pattern by altering the wettability of the support. A lyophilic surface pattern may alternatively be created.

According to the present invention there is provided a method of coating well defined discrete areas of a flexible substrate in a continuous roll to roll manner, the method comprising the steps of creating a lyophobic or lyophilic surface pattern on the substrate, a desired pattern of lyophilic or lyophobic areas being left, overcoating the created surface pattern with a layer of coating solution, the solution withdrawing from the lyophobic areas and collecting on the lyophilic areas.

Preferably the patterning of the support web is performed inline, i.e. prior to the coating solution to allow the discrete coating to be performed in a single pass.

**Advantageous Effect of the Invention**

The method of the invention enables roll to roll continuous discrete patterned coating which has significant cost and productivity benefits over batch processes. As only desired areas are coated it ensures cost effective use of materials. It enables the low cost manufacture of, for example, flexible displays, electronics, OLED's, PLEDs, touch-screens, fuel-cells, solid state lighting, photovoltaic and other complex opto-electronic devices.

**Brief Description of the Drawings**

The invention will now be described with reference to the accompanying drawings in which:

Figure 1 shows an example of a mask pattern that may be transferred onto the web of material;
Figure 2 is a graph comparing experimental results with theory;

Figure 3 shows calculated recession rates as a function of equilibrium contact angles; and
Figures 4a and 4b illustrate the improvement in coating uniformity when surfactant is added.

## Detailed Description of the Invention

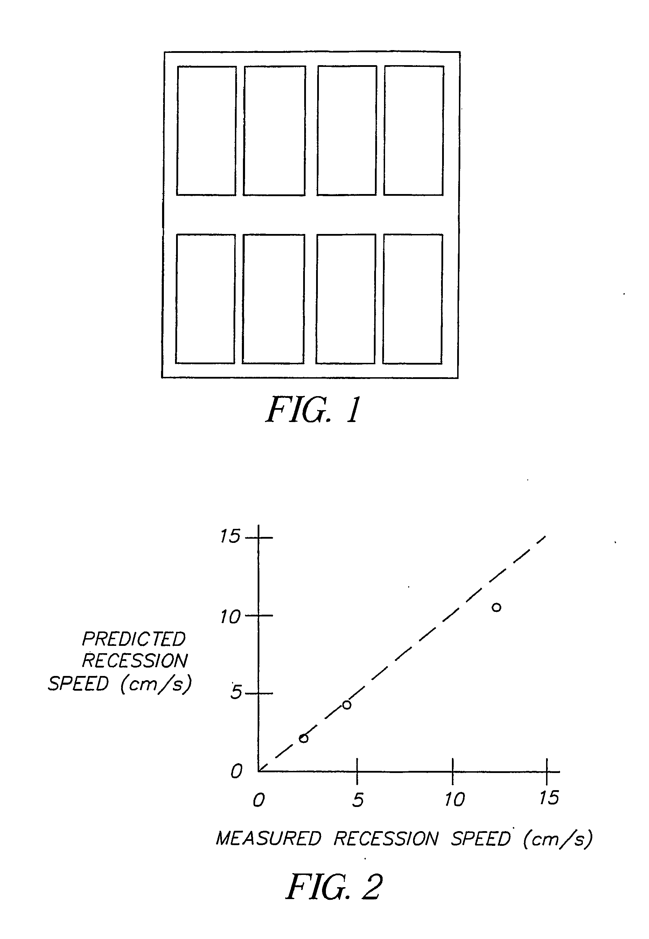

Figure 1 shows an example of a mask pattern that may be created on a web of material or substrate. The substrate may be made of paper, plastic film, resin coated paper, synthetic paper or a conductive material. These are examples only.

The invention is not limited to the pattern shown in Figure 1. A mask material may be deposited on the support using a flexographic printer roller. Alternative methods of creating the mask include; gravure coating, offset printing, screen printing, plasma deposition, photolithography, micro-contact printing, inkjet printing or selective removal of a uniform layer of the material by laser or other etching technique, optically writing with light or a laser, electrostatic spray or by plasma treatment. These are examples only and it will be understood by those skilled in the art that any suitable means may be used to create the mask pattern. The material used for the mask in the experiments described below was a layer of fluoropolymer. However the invention is not limited to such mask material. Other materials that might be used include aqueous based silicone release agents, or a chemical species containing one or more lyophobic moieties and one or more adhesive moieties.

In order to allow further layers of coating solution to be coated onto the substrate it is necessary to change the lyophobic mask or surface pattern to lyophilic so that the next layer of solution coats uniformly. This layer can then remain as a uniform layer or acts as a further substrate onto which a further mask pattern can be created and a further solution coated. Third and subsequent patterned layers would be formed in the same way. There are various methods of switching the wettabililty of the material such as temperature, light, pH, electrostatics. The materials might be based around liquid crystal polymers or alumina / titania / Teflon composites. Alternatively the original surface pattern could be removed.

Once the mask or surface pattern has been created on the web of material or substrate it is then overcoated by the desired liquid or layers of liquid. This may be done equally well by either pre or post metered coating processes. For example the coating solution may be deposited on the substrate by means of, for example, bead coating or curtain coating, by means of a blade, roll, gravure, air knife, by inkjet or by electrostatic spray. The liquid is then directed in such a way that the coated layer recedes from the lyophobic areas and collects on the lyophilic areas. When multiple layers are overcoated simultaneously the layer structure is maintained, thus allowing perfect registration of all the layers with the mask pattern. The web of material is then dried and/or cured. The liquid may be a solvent. The liquid used as the coating solution may be a gelatin based material. The coating solution may be chosen for specific properties that it may have. For instance the coating solution may be chosen for its conductive properties or photonic properties. A further example would be the use of liquid crystal material as the coating solution. The coating solution may comprise a dispersion of carbon nano tubes. This provides a coating with excellent conductivity and transparency and which may be used for the production of transparent conductors. It will be understood that the particular coating solution used will be chosen dependent on the use to which the coated web will be put. Examples include, but are not limited to, optoelectronic devices such as flexible displays and components of displays, organic lasers, light guides, lens arrays or more complex integrated optics, patterned conductive layers, lighting panels, solar cells, three dimensional structured layers of ink jet printers and microelectromechanical systems.

The speed at which the liquid or solution used as the coating layer rearranges on the masked or patterned surface of the web is an important factor in defining the speed at which the discrete areas can be coated in a roll to roll operation. The rates of recession of liquids from lyophobic surfaces can be found in published literature and theory, (as shown for example in F. Brouchard-Wyart and P. G. de Gennes, Advan. Colloid Interface Sci. 39 (1992)), predicts that the rate of recession V of a liquid film from a lyophobic solid surface should follow the simple relationship:

$$V = 0.006 \left(\frac{\gamma}{\eta}\right)(\theta)^3 \qquad\qquad (1)$$

where $\gamma$ is the surface tension of the liquid, $\eta$ is the viscosity of the liquid and $\theta$ is the equilibrium contact angle of the liquid on the mask, expressed in radians. If the liquid is coated as a uniform layer, it is necessary to destabilise the layer so that it moves from masked to unmasked regions. This may be achieved by using broad hydrophobic/oleophobic bands on the edge of the coating, or by using a device to create small circular holes in the coating at the desired time and location.

If the coating solution is dilute enough, and when it becomes sufficiently thin during drying, spontaneous dewetting from the lyophobic areas to the lyophilic areas takes place, without the need for any active destabilisation.

The following examples illustrate the method of the invention.

Both hand and machine coatings were made. Experiments were carried out using the format of an array of rectangles using a flexographic proofing system to print a mask followed either by hand coatings or bead coating. The relationship between the dewetting speed V, the surface tension $\gamma$ of the liquid, the viscosity $\eta$ of the liquid and the equilibrium contact angle $\theta$ of the liquid on the masked area was established. It was shown that the higher the contact angle of the liquid on the masked area the greater the rate of dewetting. Significant coating speeds are possible with a receding contact angle of 50°, preferably 90°, or more on the lyophobic region. In order that the coating solution does not recede from the lyophilic regions the receding angle of the solution from the lyophilic region should be as close to zero degrees as possible. For practical systems the receding angle should be less than 10° and preferably less than 5°. This will ensure good adhesion between the coating solution and the lyophilic region. It was also shown that it is preferable that the created masking surface material is highly uniform The thickness of the masking surface is of the order of 1 $\mu$m. Microscopic defects in the layer inhibit retraction of the liquid from the mask. This results in an irregular coating pattern. The coating in this instance was a gelatin melt. However a wide range of aqueous or non aqueous liquids can also be used, such as, but not limited to, conductive polymers, liquid crystals, photonic materials, OLED and PLED materials. Addition of a small amount of surfactant was also found to significantly improve the retraction rate with gelatin based solutions. The addition of surfactant can also be used to improve the uniformity of the resulting coatings.

Examples

Hydrophobic masks were printed onto 12.7cm (5 inch) wide gelatin subbed Polyethylene Teraphlalate support using a Rotary Koater flexographic printing device made by RK Print Coat Instruments Ltd. The same support material, or substrate, was used in the four examples. The photopolymer transfer roller was patterned to print the mask leaving an array of 15mm x 31mm rectangles. The pattern is shown in Figure 1

Various fluoropolymer lyophobic "inks" were printed:

a) Cytonix FluoroPel PFC 804A
b) Cytonix FluoroPel PFC GH (epoxy-based fluoropolymer, thermally cured)
c) Cytonix FluoroPel PFC 804A (approx. 16%, concentrated by rotary evaporation)
d) Cytonix FluoroPel PFC 604A
e) Cytonix FluoroPel PFC 504A

All the inks used except the concentrated PFC 804A were of low viscosity (order 1 cP).

The solutions used to overcoat the mask were as follows:

Hand coatings:

Example 1: Hand coatings with aqueous glycerol (20, 50 and 100 cP)
Example 2: Hand coating with PEDOT / PSS, Cholesteric Liquid Crystal dispersion in gelatin

Roll to roll bead coatings:

Example 3: 6% Gelatin + aqueous blue dye
Example 4: 6% Gelatin + 0.01 % 10G + aqueous blue dye

Results

Example 1.

Recession rates (taken from video recordings) for three aqueous glycerol solutions on the PFC GH mask are shown in Table 1 together with their respective viscosities, surface tensions and estimated contact angles. The contact angles were determined from video images of 200-300 microlitre drops of water (approximating aqueous glycerol) placed onto the surface of the mask under ambient conditions; surface tensions of the coating solutions were measured using a Wilhelmy blade.

**Table 1. Contact angle and recession rate data obtained with aqueous glycerol solutions.**

| Contact angle (deg) | Viscosity (cP) | Surface Tension (mN/m) | Recession Velocity (cm/s) |
|---|---|---|---|
| 100 | 100 | 64.2 | 2.2 |

(continued)

| Contact angle (deg) | Viscosity (cP) | Surface Tension (mN/m) | Recession Velocity (cm/s) |
|---|---|---|---|
| 100 | 50 | 64.9 | 4.4 |
| 100 | 20 | 65.1 | 12.3 |

Figure 2 compares these results with the predictions of equation 1.

The combined data supports equation 1 quite well, but suggests that the numerical factor should be approximately 0.007 rather than 0.006.

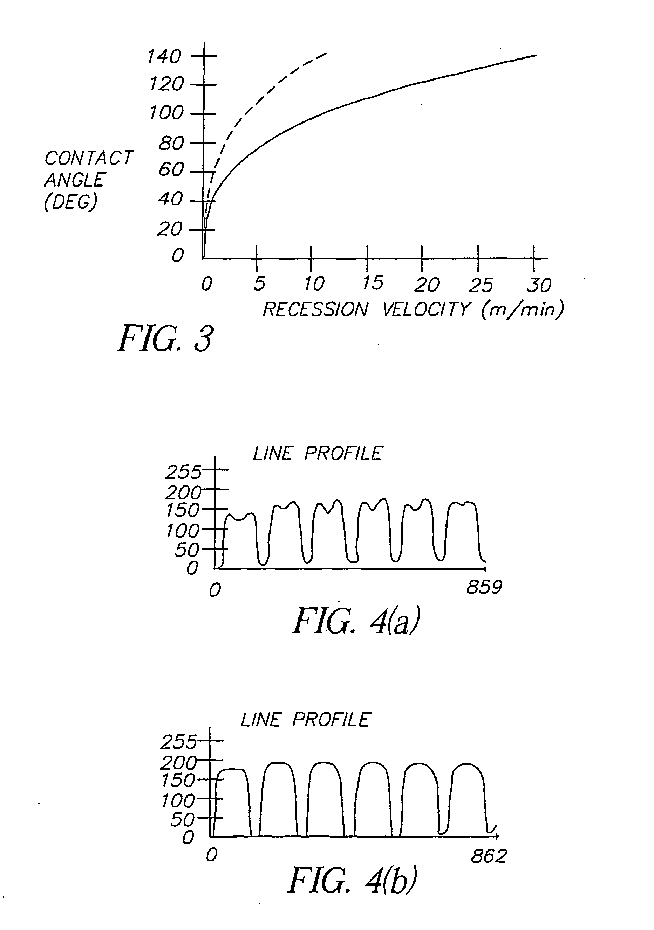

The above results enable the roll to roll speed at which continuous discrete coating can be carried out to be estimated. If reasonable parameters for coating solutions are taken, say $\gamma$ = 50-35 mN/m and $\eta$ =10-20 cP, and the numerical parameter assumed to be 0.007, then it is possible to calculate the probable recession speeds that would be available for a given contact angle. Figure 3 shows the upper and lower bounds for these values.

Example 2.

The second example used hand coatings of a gelatin based cholesteric liquid crystal (CLC) dispersion on a 604A mask material. A short section ($\sim$ 30cm long) of the hydrophobic mask was overcoated with CLC using an RK instruments K Control Koater with the blade height set to 150 micrometers and speed setting of 10. The material showed good retraction from the masked regions into the unmasked rectangles. An identical experiment using PEDOT/PSS (Aldrich) solution to overcoat the mask was also performed, again showing good retraction of the liquid into discrete coated rectangles.

Example 3.

In the third example, web speed was set at 8 m/min, with a wet laydown of coating solution of 60 micrometers. The mask material, as in example 2, was 604A. A 4 inch (10.16cm) wide bead hopper was used. Suction was varied and best results were found when suction was set low, just above break-line conditions (0.5-1cm water gauge). This appeared to provide a slight destabilising effect that triggered early onset of coating solution rupture and recession. The coatings were chilled inline soon after the coating point. For gelatin-based coating melts, it was important not to set the temperature too low, otherwise the melt set before rearrangement was complete. Best results were achieved at 30°C.

Example 4.

In the fourth example, web speed was set at 8 m/min and the wet laydown of coating solution was increased to 100 micrometers. The mask material remained the same as in example 3. Minimum suction was applied to keep the coating stable but near the break-line condition (0.7-3cm water gauge, depending on melt viscosity). Temperature was again set at 30°C. In this case the addition of the surfactant, 10G, to the coating solution improved both the retraction rate and the uniformity of the final coating. Other concentrations of the surfactant 10G were found to work, up to 1%w/w. The cross-width uniformity of the coating was also improved by the use of a device to create small holes in the coating at the correct spatial and temporal frequency so as to coincide with the intersections of the rectangles on the mask. This was achieved in the example by the use of fine air jets but may equally be achieved by any other suitable method, such as, for example, the use of small drops of repellancy forming liquid or mechanically touching the surface with a lyophobic rod.

Other non-ionic and anionic surfactants were found to improve the uniformity, e.g. Triton X200 , Triton X100, Sodium Dodecyl Sulphate, Alkanol XC, Aerosol OT

Figures 4a and 4b illustrate a line profile taken through the coating with respect to example 3 and example 4 respectively. It can be seen that example 4 shows improvement in cross width and cell uniformity.

The results of this study demonstrate that given the right selection of lyophobic inks, continuous discrete coating is capable of producing patch-wise discrete coatings by a continuous roll to roll method.

The method has particular application to coating electronic displays. However the method is not limited to such application. Continuous discrete patterned coating as described above, alone or in combination with other techniques such as screen printing, is useful in a wide range of high value products. Examples include optoelectronic devices such as flexible displays and organic lasers, light guides, lens arrays or more complex integrated optic, patterned conductive layer, lighting panels, solar cells, three dimensional structured layers of ink jet printers and microelectromechanical systems.

The invention has been described in detail with reference to preferred embodiments thereof. It will be understood by those skilled in the art that variations and modifications can be effected within the scope of the invention. For example, while the examples described have been directed towards creating a lyophobic pattern on the flexible substrate, leaving lyophilic areas, the method works equally well creating a lyophilic pattern on the substrate to leave lyophobic areas.

**Claims**

1. A method of coating well defined discrete areas of a flexible substrate in a continuous roll to roll manner, the method comprising the steps of creating a lyophobic or lyophilic surface pattern on the substrate, a desired pattern of lyophilic or lyophobic areas being left, overcoating the created surface pattern with a uniform layer of coating solution, the solution withdrawing from the lyophobic areas and collecting on the lyophilic areas, the withdrawal from the lyophobic areas being aided by destabilisation of the layer of coating solution at set spatial and temporal locations or using broad lyophobic/lyophilic bands on the edge of the coating.

2. A method as claimed in claim 1 wherein the coating solution comprises more than one distinct layer, simultaneously overcoated.

3. A method as claimed in claim 1 wherein the surface pattern is created on the substrate by means of one of: flexographic printing, offset printing, gravure printing, screen printing, lithography, inkjet (continuous or drop on demand), micro contact printing, plasma deposition, plasma treatment, electrostatic spray or optical means using light or a laser to write the pattern.

4. A method as claimed in claim 1 wherein the steps of creating a surface pattern on the substrate and overcoating the surface pattern with one or more layers of coating solution takes place inline.

5. A method as claimed in claim 1 wherein the created surface pattern comprises a fluoropolymer material.

6. A method as claimed in claim 1 wherein the created surface pattern includes a silicone release agent.

7. A method as claimed in claim 1 wherein the created surface pattern comprises a chemical species containing one or more lyophobic moieties and one or more adhesive moieties.

8. A method as claimed in claim 1 wherein the coating solution is a solvent based solution.

9. A method as claimed in claim 1 wherein the coating solution is a gelatin based material.

10. A method as claimed in claim 1 wherein the coating solution is a polymeric material.

11. A method as claimed in claim 1 wherein the coating solution has conductive and/or photonic properties.

12. A method as claimed in claim 1 wherein the coating solution comprises a dispersion of carbon nanotubes.

13. A method as claimed in claim 1 wherein the coating solution includes liquid crystal material.

14. A method as claimed in claim 1 wherein the coating solution includes surfactant.

15. A method as claimed in claim 1 wherein the coating solution is subsequently dried and/or cured.

16. A method as claimed in claim 1 wherein the surface pattern is switched from lyophobic to lyophilic, or vice versa, by means of one of: temperature, light, pH, electrostatic field, magnetic field.

17. A method as claimed in claim 16 wherein a further layer or layers of coating solution is applied over the first overcoat to create a further substrate onto which a further pattern may be created and/or further layers of coating solutions applied.

18. A method as claimed in claim 1 wherein the lyophobic surface yields a receding contact angle with the coating solution of 50° or more and the lyophilic surface yields a receding angle of 10° or less.

**19.** A method as claimed in claim 1 wherein the lyophobic surface yields a receding contact angle with the coating solution of 90° or more and the lyophilic surface yields a receding angle of 5° or less.

**20.** A method as claimed in claim 1 wherein the coating solution is deposited onto the created surface pattern by a pre-metered coating process.

**21.** A method as claimed in claim 1 wherein the coating solution is deposited onto the created surface pattern by a post metered coating process.

**22.** A method as claimed in claim 1 wherein the coating solution is deposited onto the created surface pattern by means of one of: bead coating, curtain coating, by blade, roll, gravure, air knife, inkjet, electrostatic spray.

**23.** A method as claimed in claim 1, wherein the substrate is made of a material selected from the group consisting of paper, plastic films, resin-coated paper, synthetic paper, or conductive material.

**Patentansprüche**

**1.** Verfahren zum Beschichten genau definierter, diskreter Bereiche eines biegbaren Substrats in einer kontinuierlichen Roll-to-Roll Technik, wobei das Verfahren die Schritte umfasst: Erzeugen eines lyophoben oder lyophilen Oberflächenmusters auf dem Substrat, wobei ein erwünschtes Muster aus lyophilen oder lyophoben Bereichen übrig bleibt, Beschichten des erzeugten Oberflächenmusters mit einer gleichförmigen Schicht aus einer Beschichtungslösung, wobei die Lösung sich aus den lyophoben Bereichen zurückzieht und sich in den lyophilen Bereichen sammelt und wobei der Rückzug aus den lyophoben Bereichen unterstützt wird durch Destabilisierung der Schicht aus Beschichtungslösung an bestimmten räumlichen und zeitlichen Punkten oder durch Verwendung breiter lyophober/lyophiler Bänder am Rand der Beschichtung.

**2.** Verfahren nach Anspruch 1, worin die Beschichtungslösung mehr als eine ausgeprägte Schicht umfasst, wobei die Schichten gleichzeitig beschichtet wurden.

**3.** Verfahren nach Anspruch 1, worin das Oberflächenmuster auf dem Substrat mit Hilfe eines der folgenden Verfahren oder eines der folgenden Mittel erzeugt wird: eines Flexodruck-, Offsetdruck-, Tiefdruck-, Siebdruck-, Lithografie-, Tintenstrahldruck-(kontinuierlich oder Drop-on-Demand) oder Mikrokontaktdruckverfahrens, einer Plasmaablagerung, einer Plasmabehandlung, eines elektrostatischen Sprays oder optischer Mittel unter Verwendung von Licht oder einem Laser, um das Muster zu schreiben.

**4.** Verfahren nach Anspruch 1, worin die Schritte des Erzeugens eines Oberflächenmusters auf dem Substrat und des Beschichtens des Oberflächenmusters mit einer oder mehreren Schichten einer Beschichtungslösung in einer Linie erfolgen.

**5.** Verfahren nach Anspruch 1, worin das erzeugte Oberflächenmuster ein fluorpolymeres Material aufweist.

**6.** Verfahren nach Anspruch 1, worin das erzeugte Oberflächenmuster ein Silicium freisetzendes Mittel aufweist.

**7.** Verfahren nach Anspruch 1, worin das erzeugte Oberflächenmuster ein chemisches Mittel aufweist mit einem oder mehreren lyophoben Teilen und einem oder mehreren adhäsiven Teilen.

**8.** Verfahren nach Anspruch 1, worin die Beschichtungslösung eine lösungsmittelhaltige Lösung aufweist.

**9.** Verfahren nach Anspruch 1, worin die Beschichtungslösung ein gelatinehaltiges Material aufweist.

**10.** Verfahren nach Anspruch 1, worin die Beschichtungslösung ein polymeres Material ist.

**11.** Verfahren nach Anspruch 1, worin die Beschichtungslösung leitende und/oder photonische Eigenschaften aufweist.

**12.** Verfahren nach Anspruch 1, worin die Beschichtungslösung eine Dispersion aus Kohlenstoff-Nanoröhren aufweist.

**13.** Verfahren nach Anspruch 1, worin die Beschichtungslösung ein Material aus Flüssigkristallen aufweist.

**14.** Verfahren nach Anspruch 1, worin die Beschichtungslösung einen grenzflächenaktiven Stoff aufweist.

**15.** Verfahren nach Anspruch 1, worin die Beschichtungslösung anschließend getrocknet und/oder ausgehärtet wird.

**16.** Verfahren nach Anspruch 1, worin das Oberflächenmuster von lyophob auf lyophil oder umgekehrt geschaltet wird mittels Temperatur, Licht, einem pH-Wert, einem elektrostatischen Feld oder einem Magnetfeld.

**17.** Verfahren nach Anspruch 16, worin eine weitere Schicht oder weitere Schichten aus Beschichtungslösung auf der ersten Beschichtung aufgebracht wird bzw. werden, um ein weiteres Substrat zu erzeugen, auf dem ein weiteres Muster erzeugbar ist und/oder weitere Schichten aus Beschichtungslösung aufbringbar sind.

**18.** Verfahren nach Anspruch 1, worin die lyophobe Oberfläche mit der Beschichtungslösung einen Rückzugskontaktwinkel von mindestens 50° ergibt und die lyophile Oberfläche einen Rückzugswinkel von höchstens 10° ergibt.

**19.** Verfahren nach Anspruch 1, worin die lyophobe Oberfläche mit der Beschichtungslösung einen Rückzugskontaktwinkel von mindestens 90° ergibt und die lyophile Oberfläche einen Rückzugswinkel von höchstens 5° ergibt.

**20.** Verfahren nach Anspruch 1, worin die Beschichtungslösung auf dem erzeugten Oberflächenmuster mittels eines vorab bemessenen Beschichtungsverfahrens aufgebracht wird.

**21.** Verfahren nach Anspruch 1, worin die Beschichtungslösung auf dem erzeugten Oberflächenmuster mittels eines nachträglich bemessenen Beschichtungsverfahrens aufgebracht wird.

**22.** Verfahren nach Anspruch 1, worin die Beschichtungslösung auf dem erzeugten Oberflächenmuster aufgebracht wird mittels eines Wulstbeschichtungsverfahrens, eines Vorhangbeschichtungsverfahrens, einer Klinge, einer Walze, eines Tiefdruckverfahrens, einer Luftbürste, eines Tintenstrahlverfahrens oder eines elektrostatischen Sprays.

**23.** Verfahren nach Anspruch 1, worin das Substrat aus einem Material besteht, das ausgewählt ist aus der Gruppe bestehend aus Papier, einer Kunststofffolie, harzbeschichtetem Papier, synthetischem Papier oder leitfähigem Material.

**Revendications**

**1.** Procédé de couchage de zones séparées bien définies d'un substrat souple selon une manière en continu rouleau sur rouleau, le procédé comprenant les étapes consistant à créer un motif de surface lyophobe ou lyophile sur le substrat, un motif souhaité de zones lyophiles ou lyophobes étant laissé, recouvrir le motif de surface créé d'une couche uniforme de solution de couchage, la solution se retirant des zones lyophobes et s'accumulant sur les zones lyophiles, le retrait des zones lyophobes étant assisté par la déstabilisation de la couche de la solution de couchage à des emplacements établis dans l'espace et dans le temps ou par l'utilisation de larges bandes lyophobes/lyophiles sur le bord du couchage.

**2.** Procédé selon la revendication 1, dans lequel la solution de couchage comprend plus d'une couche distincte, simultanément recouvertes.

**3.** Procédé selon la revendication 1, dans lequel le motif de surface est créé sur le substrat au moyen d'une technique parmi : une impression flexographique, une impression offset, une héliogravure, une sérigraphie, une lithographie, une impression par jet d'encre (en continu ou à la demande), une impression par micro-contact, une projection de plasma, un traitement par plasma, une projection électrostatique ou un moyen optique utilisant de la lumière ou un laser pour écrire le motif.

**4.** Procédé selon la revendication 1, dans lequel les étapes consistant à créer un motif de surface sur le substrat et à recouvrir le motif de surface d'une ou plusieurs couches d'une solution de couchage se produisent en série.

**5.** Procédé selon la revendication 1, dans lequel le motif de surface créé comprend un matériau de polymère fluoré.

**6.** Procédé selon la revendication 1, dans lequel le motif de surface créé comprend un agent de libération de silicone.

7. Procédé selon la revendication 1, dans lequel le motif de surface créé comprend une espèce chimique contenant un ou plusieurs groupes caractéristiques lyophobes et un ou plusieurs groupes caractéristiques adhésifs.

8. Procédé selon la revendication 1, dans lequel la solution de couchage est une solution à base de solvant.

9. Procédé selon la revendication 1, dans lequel la solution de couchage est un matériau à base de gélatine.

10. Procédé selon la revendication 1, dans lequel la solution de couchage est un matériau polymère.

11. Procédé selon la revendication 1, dans lequel la solution de couchage a des propriétés conductrices et/ou photoniques.

12. Procédé selon la revendication 1, dans lequel la solution de couchage comprend une dispersion de nanotubes de carbone.

13. Procédé selon la revendication 1, dans lequel la solution de couchage comprend un matériau à cristaux liquides.

14. Procédé selon la revendication 1, dans lequel la solution de couchage comprend un agent tensioactif.

15. Procédé selon la revendication 1, dans lequel la solution de couchage est ensuite séchée et/ou polymérisée.

16. Procédé selon la revendication 1, dans lequel le motif de surface passe de l'état lyophobe à l'état lyophile, ou vice versa, au moyen d'un élément parmi : la température, la lumière, le pH, un champ électrostatique, un champ magnétique.

17. Procédé selon la revendication 16, dans lequel une autre couche ou d'autres couches d'une solution de couchage sont appliquées sur la première sur couche pour créer un autre substrat sur lequel un motif supplémentaire peut être créé et/ou d'autres couches de solutions de couchage peuvent être appliquées.

18. Procédé selon la revendication 1, dans lequel la surface lyophile fournit un angle de contact sortant avec la solution de couchage de 50° ou plus et la surface lyophile fournit un angle sortant de 10° ou moins.

19. Procédé selon la revendication 1, dans lequel la surface lyophile fournit un angle de contact sortant avec la solution de couchage de 90° ou plus et la surface lyophile fournit un angle sortant de 5° ou moins.

20. Procédé selon la revendication 1, dans lequel la solution de couchage est déposée sur le motif de surface créé par un procédé de couchage mesuré au préalable.

21. Procédé selon la revendication 1, dans lequel la solution de couchage est déposée sur le motif de surface créé par un procédé de couchage mesuré ultérieurement.

22. Procédé selon la revendication 1, dans lequel la solution de couchage est déposée sur le motif de surface créé au moyen d'une technique parmi : un couchage à bourrelet, un couchage par voile, par lame, rouleau, gravure, lame d'air, jet d'encre, pulvérisation électrostatique.

23. Procédé selon la revendication 1, dans lequel le substrat est constitué d'un matériau sélectionné à partir du groupe constitué du papier, de films de matières plastiques, de papier polyéthylène, de papier synthétique, ou d'un matériau conducteur.

*FIG. 1*

PREDICTED
RECESSION
SPEED (cm/s)

MEASURED RECESSION SPEED (cm/s)

*FIG. 2*

FIG. 3

FIG. 4(a)

FIG. 4(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0238386 A
- EP 0882593 A
- WO 0162400 A
- US 6048623 A
- WO 0147045 A

**Non-patent literature cited in the description**

- **F. Brouchard-Wyart ; P. G. de Gennes.** *Advan. Colloid Interface Sci.,* 1992, vol. 39